# EUROPEAN PATENT SPECIFICATION

(11) **EP 2 244 544 B1**
(45) Date of publication and mention of the grant of the patent: **26.10.2011**
(21) Application number: 09158551.3
(22) Date of filing: 23.04.2009
(51) Int. Cl.: H05K 7/14

(54) **Hardware module and backplane board for an IED**
Hardwaremodul und Rückwandplatine für USBV
Module matériel et panneau arrière pour un dispositif intelligent

(43) Date of publication of application: 27.10.2010
(73) Proprietor: ABB Technology AG, 8050 Zürich (CH)
(72) Inventor: Gloor, Mathias, CH-4814, Bottenwil (CH); Borner, Christian, CH-5213, Villnachern (CH)
(74) Representative: ABB Patent Attorneys

(56) References cited:
- WO-A-2007/006267
- US-A- 5 726 635
- US-A1- 2002 006 026
- US-B1- 6 650 844

## Description

### FIELD OF THE INVENTION

The invention relates to the field of device-internal communication in Intelligent Electronic Devices for Substation Automation. It departs from a hardware module or card as described in the preamble of claim 1.

### BACKGROUND OF THE INVENTION

Substations in high and medium-voltage electric power networks include primary devices such as electrical cables, lines, bus bars, switching devices and power transformers. These primary devices are operated in an automated way via a Substation Automation (SA) system. The SA system comprises secondary devices, among which Intelligent Electronic Devices (IED) are responsible for protection, control and monitoring of the primary devices. The IEDs control actuators of assigned primary devices on the base of signals from assigned sensors for switch or transformer tap changer position, temperature, voltage, current etc., signals from other IEDs, and signals from a supervisory system. Conversely, an IED communicates a state or behaviour of its assigned primary devices, i.e. selected sensor readings, to other IEDs or to the supervisory system. Depending on their intended location in the substation, and in particular on the proximity to the primary devices, the IEDs need to meet certain environment withstanding and Electromagnetic Compatibility (EMC) requirements.

In modular IEDs, a plurality of modules or cards, each comprising a Printed Circuit Board (PCB) and electronic components mounted thereon, are connected via backplane connectors to an interconnecting backplane bus. The latter may operate e.g. according to a point-to-point bus topology, which involves a dedicated driver and receiver pair per channel. A limited number of transitions from one medium to the next (i.e. a transition from a printed circuit board to a cable via a connector) imply that the channel will most likely have well-controlled impedance, which in turn allows very high signaling rates. In particular, Low Voltage Differential Signaling (LVDS), Current Mode Logic (CML), and Low Voltage Positive Emitter Coupled Logic (LVPECL) are differential signaling technologies designed for point-to-point signal transmission, with driver-output signals comprising fast edges that allow multi-gigabit transmission. For instance, the 350 mV typical signal swing of LVDS enables data rates of up to 3 Gbps while consuming only a small amount of power.

Accordingly LVDS is considered a very efficient technology, despite of the fact that the fast signal edges are very sensitive to any impedance discontinuities and demand careful interconnect designs. The so-called interconnect, or physical signal path, typically consists of two printed conductor traces on a backplane board. Controlled impedance of interconnect, proper driver load, and interconnect termination are the key points for consideration when designing for low-jitter signal transmission. A particular economic advantage resides in the fact that a single cost-cutting Field-Programmable Gate Array (FPGA)-internal LVDS driver may provide sufficient signal quality and sufficient transmission power for point-to-point communication. On the other hand, multipoint topologies, and in particular "multi-drop' topologies with a single driver and multiple receivers per channel, require additional amplification of the transmitted signal.

The backplane board, in addition to hosting the backplane bus, is generally adapted to distribute additional signals, such as e.g. clock signals, as well as to provide power supply voltage to the modules. In some IEDs the width of the modules, i.e. their maximum extension in a direction perpendicular to the PCB as essentially defined by tallest components mounted thereon may not be uniform. This is the case e.g. for I/O modules, comprising a plurality of clamps for hard-wiring Cu cables to various Instrument Transformers or other analogue / binary signal sources, or comprising bulky components such as current / voltage transformers mounted on the PCB. If the number of such oversized modules and their arrangement relative to the other, standard-sized modules is not to be predefined upfront, the backplane board may be equipped with uniformly spaced slots for accommodating the modules, with a uniform lateral spacing according to the maximum module width. This however amounts to an unwanted waste of space. As a cost-wise less advantageous alternative with a backplane bus somewhat detached from the backplane board, a flat ribbon cabling may be used for flexible and space-saving point to point connection between the modules.

Such a hardware module is known e.g from the document US-B1-6 650 844.

### DESCRIPTION OF THE INVENTION

It is therefore an objective of the invention to enable a flexible and space-saving arrangement of modules in an Intelligent Electronic Device (IED). This objective is achieved by a hardware module and a backplane board according to the claims 1 and 5, respectively. Further preferred embodiments are evident from the dependent patent claims.

According to the invention, a hardware module for an IED is adapted to engage a slot or socket of a backplane of the IED in order to communicate, in a point-to-point mode over a serial backplane bus system that encompasses said slot, with two neighbouring modules in the IED. The module comprises a source selector to select, in receiving mode, between reception of signals transmitted via a nearest neighbour slot, which is preferred, or via a next-nearest neighbour slot. In this context, "near" and "nearest neighbour" refer to the spatial, and in particular linear, arrangement of the slots on the backplane of the IED with respect to the slot engaged by the hardware module itself. It is further understood that the next-nearest neighbour slot in turn is a nearest neighbour slot to the original nearest neighbour slot. The source selector evaluates signals directed towards a rear side of a circuit board of the module, with the rear side being substantially devoid of electronic components. This communication direction is designated "down" direction in the following.

In a preferred variant of the invention, the module itself is adapted to transmit a signal in the "down" direction in parallel to both a nearest slot and a next-nearest neighbour slot.

In a further preferred variant of the invention, the module is permanently configured to receive exclusively, in an "up" direction opposite to the "down" direction, signals from a neighbouring module engaging a nearest slot if the module has a standard width, or from a neighbouring module engaging a next-nearest slot if the width of the module exceeds a standard width.

In general, Field-Programmable Gate Array (FPGA) internal LVDS drivers are powerful enough for a backplane bus using Low Voltage Differential Signaling (LVDS) in a full duplex topology.

In an advantageous embodiment of the invention, a backplane board comprises a number of evenly distributed slots for accommodating modules, wherein a lateral distance between the slots correlates with the standard module width, and wherein the engaging modules preferably form an arrangement of extension boards geometrically oriented in parallel. Two signal paths or channels, printed on otherwise supported by the backplane board, terminate at each slot and connect the latter to a source at a nearest and a next-nearest slot.

Each of the two signal paths may be a completely individual or isolated path interconnecting two slots. Alternatively, both signal paths may comprise a bifurcation or junction, from which another signal path branches off. The two branches having a common origin at a particular source slot terminate at a nearest and next-nearest neighbour slot of the source slot, respectively. This topology requires a single signal driver per source module and communication direction, and is advantageously employed in "up" direction, where termination resistance and receiver are connected to only one of the two branches.

An IED comprising a backplane and hardware module as described above is particularly suited for a use in Substation Automation, as it minimizes space requirements and presents a backplane bus connection topology that gives rise to only a limited number of relatively short unused stub lines, and thus results in high signal integrity and very good Electromagnetic Compatibility (EMC) and Electrostatic Discharge (ESD) strength.

### BRIEF DESCRIPTION OF THE DRAWINGS

The subject matter of the invention will be explained in more detail in the following text with reference to preferred exemplary embodiments which are illustrated in the attached drawings, in which:
- Fig.1: schematically depicts a cross-sectional view of an IED with five modules,
- Fig.2: depicts a top view of a backplane with five slots,
- Fig.3: is a table summarizing the signal flow between four neighbouring slots, and
- Fig.4: shows some inter-module routing paths, unused lines and unused stub lines.

The reference symbols used in the drawings, and their meanings, are listed in summary form in the list of designations. In principle, identical parts are provided with the same reference symbols in the figures.

### DETAILED DESCRIPTION OF PREFERRED EMBODIMENTS

Modem IEDs in Substation Automation often use a serial high-speed signaling with point-to-point topology in order to exchange data packets between a base or master module and extension modules comprising multiple functionality for protection, control and monitoring purposes in electric power systems. All connections regarding data exchange between modules are done via a passive backplane Printed Circuit Board (PCB). Data packets are forwarded from module to module until the destination module is reached. In order to accommodate modules with a width exceeding the distance between two physical slots of the backplane board some kind of selecting or switching mechanism is needed to ensure communication either to the next slot or to the next-but-one slot.

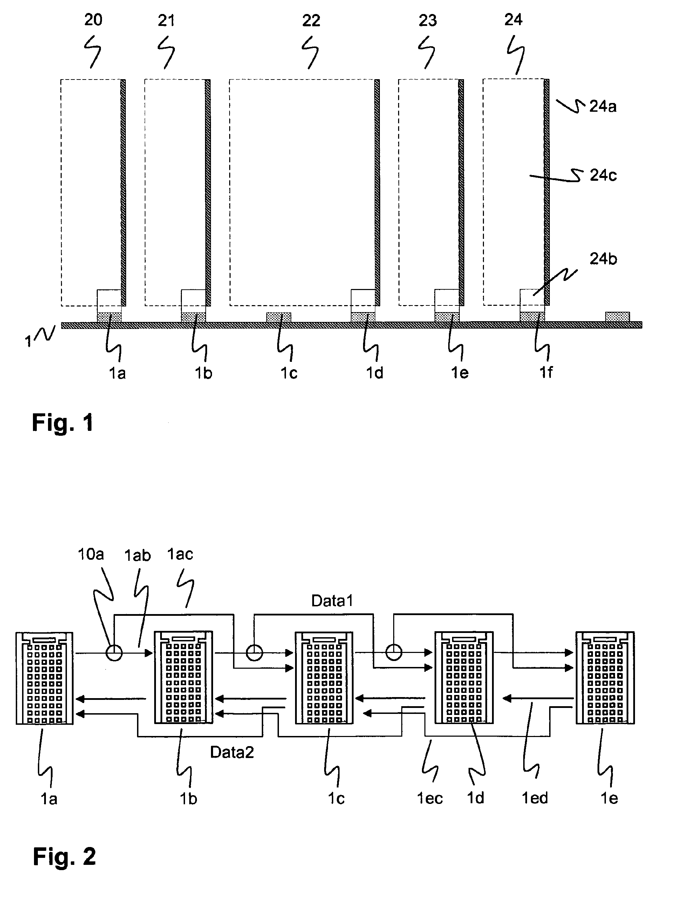

Fig.1 schematically depicts a cross-sectional, IED-internal view along the intersection of a backplane board 1 and the modules 20 to 24 arranged on the backplane board. Each of the modules comprises a PCB 24a and a backplane connector 24b for electrically connecting the module to the backplane. To the left of each PCB, a space 24c for the electronic components is indicated with broken lines, wherein the central module 22 clearly has a width that is somewhere between the single and double of the standard width of the other modules. On the backplane board, equally spaced slots 1a to 1f are arranged, wherein the distance between two neighbouring slots corresponds to the standard module width.

Fig.2 schematically depicts a top view of the backplane with five slots 1a to 1e, each in the form of a rectangular array of 55 individual pin connectors, i.e. male or female type connectors to engage with corresponding counterpart connectors of a backplane connector. The electrical connections between the slots are depicted as solid lines, wherein each connection or line corresponds to two conductor traces (positive and negative) printed on the backplane board and terminating at a pair of two of the above pin connectors. A Data1 signal is propagated from the left-most slot 1a, accommodating a basic or master module, in an "up" direction to the other slots 1b to 1e that in turn accommodate extension modules (no modules shown in Fig.2). All "up" connections between neighbouring modules comprise a bifurcation or "Y"-junction 10a, from which the Data1 signal is further transmitted in parallel over two branch lines 1ab, 1ac to both the nearest 1b and the next nearest 1c slot. Hence, any "up" signal as sent by a source module via a single pair of pins is inherently destined to two neighbouring slots. On the other hand, Data2 signals that are propagated in a "down" direction from right to left can do so via two entirely distinct paths 1ed, 1ec, both originating at distinct pairs of pin connectors at the source slot 1e and terminating at the nearest 1d and next nearest 1c neighbour slot, respectively.

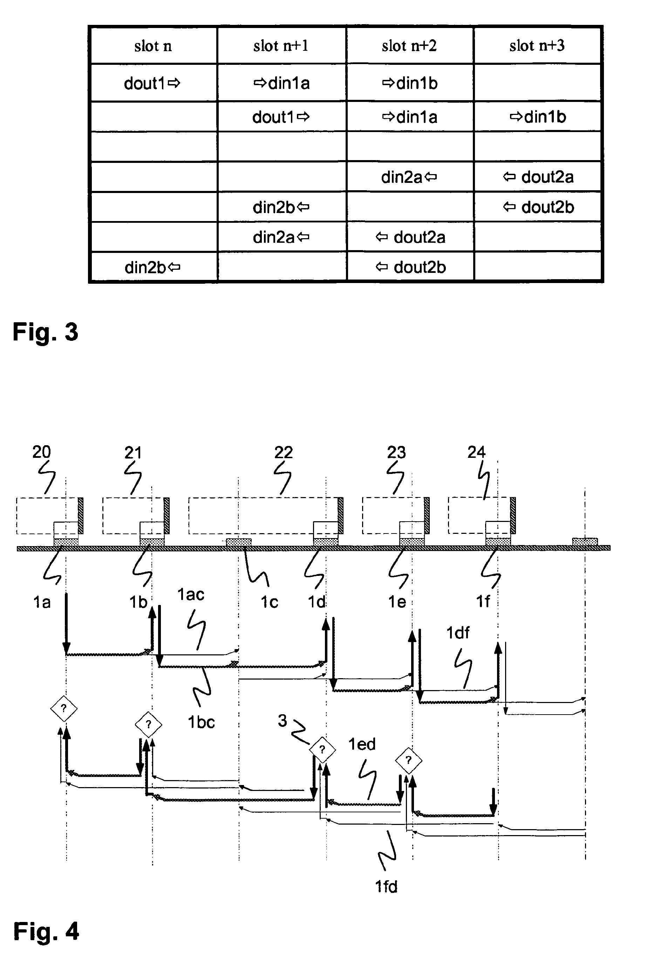

Fig.3 is a table summarizing the above signal flow between four neighbouring slots. The "up" signal Data1 is generated as dout1 and received as din1a at the near neighbour and as din1b at the far neighbour. The "down" signals Data2 are prepared as dout2a and dout2b, and received as din2a and din2b at the near and far neighbour, respectively.

In Fig.4 the modules of Fig.1 are depicted in part, together with intra-module routing paths as indicated by vertical arrows underneath each module, as well as inter-module routing paths as indicated by horizontal arrows. Inter-module communication comprises, in an "up" direction from left to right, sending, by the first and left-most module 20, a message to the second module 21 (bold arrow). By virtue of the abovementioned bifurcation 10a at or near slot 1b, the same signal is also sent to unused slot 1c along an unused branch or stub line 1ac. The second module 21 in turn sends signals along a dedicated trace on the backplane board to slot 1c, and further to slot 1d which accommodates oversized module 22. Module 22 further transmits the "up" signals to neighbouring modules 23 and 24. However, with module 24 being aware of its standard width and hence of the fact that a close neighbouring module 23 must exist, the signal from module 22 is ignored by module 24, which in turn makes branch 1df a unused stub line. This is most easily achieved by omitting or interrupting, on the PCB of module 24, the conductor trace leading to the counterpart connectors of branch 1df. Signal quality considerations of the "up" Data1 in the above embodiments does not require a termination resistance for the unused branches, neither on the backplane board nor on the module itself.

In the bottom half of Fig.4, every transmitting module sends the Data2 signals in the opposite or "down" direction (from right to left) on distinct paths to both the nearest and the next-nearest neighbour. Since exemplary receiving module 22 has a termination resistor of 100 Ohm for both the path 1ed from the nearest neighbour module 23 and the path 1fd from the next-nearest neighbour module 24, it is in a position to determine if the differential voltage is close to 0 Volt, or if there is a LV driver at the other end of each signal path. The receiving module may thus determine whether or not the signal from the nearest neighbour (data2a) and/or the signal from the next nearest neighbour (data2b) do exist. In case both signals are received, the one from the near neighbour 23 is chosen for further processing, making the entire path 1fd from the far neighbour 24 an unused line with proper termination. On the other hand, if during a specific amount of time of typically 100 ns following power-up or after a reset no signal from the near located module is detected, a source selector 3 at the receiver automatically chooses the signal from the far located module. During normal operation and until the next power-up or reset process is initiated, the above choice generally remains unchallenged.

### LIST OF DESIGNATIONS

- 1: backplane board
- 1a - 1f: slot
- 1ab, 1ac, 1df: "up" branch
- 1ed, 1ec, 1fd: "down" path
- 10a: bifurcation
- 20 - 24: module
- 20a: PCB
- 20b: backplane connector
- 20c: space for electronic components
- 3: source selector

## Claims

1. A hardware module (20-24) for an Intelligent Electronic Device IED, comprising a circuit board (24a), electronic components mounted on the circuit board, and a backplane connector (24b) for engaging a slot (1a-1f) of a backplane (1) of the IED, the module (20-24) being adapted to receive, over a serial backplane bus, and to process a signal from a source module (22; 23) of the IED,
**characterized in that** the module (20-24) comprises a source selector (3) adapted to determine whether a neighbouring module engages the nearest slot (1c; 1e) of the backplane and to, in the affirmative, elect this module (23) as the source module, as well as to, in the negative, elect a neighbouring module (22) engaging the next-nearest slot (1d) of the backplane as the source module.

2. The module according to claim 1, **characterized in that** it is adapted to transmit, as a source module (23), a signal to a nearest slot (1d) as well as to a next-nearest slot (1c).

3. The module according to claim 1, **characterized in that** it is configured to receive, according to a width of the module (20-24), signals from a nearest (1a) or a next-nearest (1b) slot of the backplane.

4. The module according to claim 1, **characterized in that** it comprises a Field-Programmable Gate Array FPGA with an embedded driver for Low Voltage Differential Signaling LVDS.

5. A backplane board (1) for an IED, comprising regularly spaced slots (1a-1f) and adapted to accommodate and communicatively interconnect, via a serial backplane bus, a number of hardware modules (20-24) according to one of the preceding claims, **characterized in that** the backplane board comprises two signal paths (1bc, 1ac; 1ed, 1fd) leading to a slot (1c; 1d) and originating at a nearest (1b; 1e) and a next-nearest slot (1a; 1f).

6. The backplane board according to claim 5, **characterized in that** the signal path from the next-nearest slot (1a) comprises a bifurcation (10a), from which another signal path (1ab) leads to the nearest slot (1b).

7. A use of a backplane board according to claim 5 or 6 and hardware modules according to claim 1 to 4 in an IED for Substation Automation.

## Patentansprüche

1. Hardwaremodul (20-24) für eine intelligente elektronische Einrichtung IED, umfassend eine Leiterplatte (24a), auf der Leiterplatte angebrachte elektronische Komponenten und einen Rückwandverbinder (24b) zum Ineingriffnehmen eines Steckplatzes (1a-1f) einer Rückwand (1) der IED, wobei das Modul (20-24) dafür ausgelegt ist, über einen seriellen Rückwandbus ein Signal von einem Quellenmodul (22; 23) der IED zu empfangen und zu verarbeiten,
**dadurch gekennzeichnet, dass** das Modul (20-24) einen Quellenselektor (3) umfasst, der dafür ausgelegt ist, zu bestimmen, ob ein benachbartes Modul den nächsten Steckplatz (1c; 1e) der Rückwand in Eingriff nimmt, und im bestätigenden Fall dieses Modul (23) als das Quellenmodul zu wählen sowie im negativen Fall ein benachbartes Modul (22), das den übernächsten Steckplatz (1d) der Rückwand in Eingriff nimmt, als das Quellenmodul zu wählen.

2. Modul nach Anspruch 1, **dadurch gekennzeichnet, dass** es dafür ausgelegt ist, als ein Quellenmodul (23) ein Signal zu dem nächsten Steckplatz (1d) sowie zu einem übernächsten Steckplatz (1c) zu senden.

3. Modul nach Anspruch 1, **dadurch gekennzeichnet, dass** es dafür ausgelegt ist, gemäß einer Breite des Moduls (20-24) Signale von einem nächsten (1a) oder übernächsten (1b) Steckplatz der Rückwand zu empfangen.

4. Modul nach Anspruch 1, **dadurch gekennzeichnet, dass** es ein Field-Programmable Gate Array FPGA mit einem eingebetteten Treiber für Low Voltage Differential Signaling LVDS umfasst.

5. Rückwandplatine (1) für eine IED, die regelmäßig beabstandete Steckplätze (1a-1f) umfasst und dafür ausgelegt ist, über einen seriellen Rückwandbus eine Anzahl von Hardwaremodulen (20-24) nach einem der vorhergehenden Ansprüche aufzunehmen und kommunikativ zu verbinden,
**dadurch gekennzeichnet, dass** die Rückwandplatine zwei Signalpfade (1bc, 1ac; 1ed, 1fd) umfasst, die zu einem Steckplatz (1c; 1d) führen und aus einem nächsten (1b; 1e) und einem übernächsten Steckplatz (1a; 1f) stammen.

6. Rückwandplatine nach Anspruch 5, **dadurch gekennzeichnet, dass** der Signalpfad von dem übernächsten Steckplatz (1a) eine Gabelung (10a) umfasst, aus der ein anderer Signalpfad (1ab) zu dem nächsten Steckplatz (1b) führt.

7. Verwendung einer Rückwandplatine nach Anspruch 5 oder 6 und von Hardwaremodulen nach Anspruch 1 bis 4 in einer IED zur Unterwerkautomatisierung.

## Revendications

1. Module matériel (20-24) pour un dispositif électronique intelligent IED, comprenant une carte de circuit imprimé (24a), des composants électroniques montés sur la carte de circuit imprimé, et un connecteur de fond de panier (24b) pour engager une fente (1a-1f) d'un fond de panier (1) de l'IED, le module (20-24) étant adapté pour recevoir, sur un bus de fond de panier en série, et pour traiter un signal provenant d'un module source (22 ; 23) de l'IED,
**caractérisé en ce que** le module (20-24) comprend un sélecteur de source (3) adapté pour déterminer si un module voisin engage la fente la plus proche (1e ; 1e) du fond de panier et, dans l'affirmative, pour désigner ce module (23) comme le module source, et aussi, dans la négative, pour désigner un module voisin (22) engageant la fente la plus proche suivante (1d) du fond de panier comme le module source.

2. Module selon la revendication 1, **caractérisé en ce qu'**il est adapté pour transmettre, en tant que module source (23), un signal à la fente la plus proche (1d) et également à la fente la plus proche suivante (1c).

3. Module selon la revendication 1, **caractérisé en ce qu'**il est configuré pour recevoir, en fonction de la largeur du module (20-24), des signaux provenant de la fente la plus proche (1a) ou la plus proche suivante (1b) du fond de panier.

4. Module selon la revendication 1, **caractérisé en ce qu'**il comprend un réseau prédiffusé programmable FPGA avec un lecteur intégré pour la signalisation différentielle à basse tension LVDS.

5. Carte de fond de panier (1) pour un IED, comprenant des fentes régulièrement espacées (1a-1f), et adaptée pour accueillir et interconnecter de manière communicante, par l'intermédiaire d'un bus de fond de panier en série, un certain nombre de modules matériels (20-24) selon l'une des revendications précédentes,
**caractérisée en ce que** la carte de fond de panier comprend deux voies de signalisation (1bc, 1ac ; 1ed, 1fd) conduisant à une fente (1c ; 1d) et provenant de la fente la plus proche (1b ; 1e) et la plus proche suivante (1a ; 1f).

6. Carte de fond de panier selon la revendication 5, **caractérisée en ce que** le trajet de signal provenant de la fente la plus proche suivante (1a) comprend une bifurcation (10a), depuis laquelle un autre trajet de signal (1ab) conduit à la fente la plus proche (1b).

7. Utilisation d'une carte de fond de panier selon la revendication 5 ou 6 et de modules matériels selon l'une des revendications 1 à 4 dans un IED pour l'automatisation d'une sous-station.
